# EUROPEAN PATENT APPLICATION

(11) **EP 4 783 459 A1**
(43) Date of publication of application: **29.07.2026**
(21) Application number: 26152107.4
(22) Date of filing: 15.01.2026
(51) Int. Cl.: H03F 1/56, H03F 1/22, H03F 1/02, H03F 3/193, H03F 3/24, H03F 3/72

(54) **WIRELESS CIRCUITRY WITH SCAN AMPLIFIER**

(30) Priority: 28.01.2025 US 202519039116
(71) Applicant: Apple Inc., Cupertino, CA 95014 (US)
(72) Inventor: TAVAKOLI TABA, Morteza, Cupertino, CA 95014 (US); GAMBINI, Simone, Cupertino, CA 95014 (US)
(74) Representative: Karl, Christof

(57) **Abstract**

Wireless circuitry may include a primary receiver with a primary low noise amplifier (LNA) and a scan receiver with a scan LNA. The wireless circuitry may be switchable between a coexistence mode and a scan mode. In the scan mode, the scan receiver and the scan LNA are active while the primary receiver and the primary LNA are inactive. Circuitry in the scan LNA may perform impedance matching to the off-chip matching network. This may allow for impedance matching in the scan-only mode without use of an external resistive termination that would otherwise deteriorates the noise figure of the receivers. Detection of a signal using the scan receiver may trigger the wireless circuitry to switch to the coexistence mode. In the coexistence mode, both the primary receiver and the scan receiver are active. Circuitry in the primary LNA may perform impedance matching to an off-chip matching network.

## Description

This application claims priority to U.S. patent application No. 19/039,116, filed January 28, 2025, which is hereby incorporated by reference herein in its entirety.

### Field

This disclosure relates generally to electronic devices, including electronic devices with wireless circuitry.

### Background

Electronic devices can be provided with wireless communications capabilities. An electronic device with wireless communications capabilities has wireless communications circuitry with one or more antennas. Wireless transceiver circuitry in the wireless communications circuitry uses the antennas to transmit and receive radio-frequency signals.

Radio-frequency signals transmitted by an antenna can be fed through a power amplifier, which is configured to amplify low power analog signals to higher power signals more suitable for transmission through the air over long distances. Radio-frequency signals received at an antenna can be fed through a low noise amplifier, which is configured to amplify low power analog signals to higher power signals for ease of processing at a receiver. It can be challenging to design satisfactory low noise amplifiers for an electronic device.

### Summary

An electronic device may include wireless circuitry. The wireless circuitry may include a primary receiver and a scan receiver. The primary receiver may include a primary low noise amplifier (LNA). The scan receiver may include a scan LNA. The wireless circuitry may be switchable between a coexistence mode and a scan-only mode. In the scan-only mode, the scan receiver and the scan LNA are active while the primary receiver and the primary LNA are inactive. Circuitry in the scan LNA may perform impedance matching to the off-chip matching network. This may allow for impedance matching in the scan-only mode without use of an external resistive termination that would otherwise deteriorate the noise figures of the receivers. Detection of a signal using the scan receiver may trigger the wireless circuitry to switch to the coexistence mode. In the coexistence mode, both the primary receiver and the scan receiver are active. Circuitry in the primary LNA may perform impedance matching to an off-chip matching network.

The scan LNA may include a coexistence path, a gain control path, and a scan path coupled in parallel between an input and an output. The coexistence path may be active and the scan path may be inactive in the coexistence mode. The coexistence path may be inactive and the scan path may be active in the scan-only mode. The gain control path may be active in the scan-only mode and the coexistence mode. The coexistence path may include a first cascode amplifier. The gain control path may include a second cascode amplifier. The scan path may include a common source amplifier. A feedback capacitance may be coupled between drain terminals of first and second transistors of the common source amplifier and gate terminals of the first and second transistors. The feedback capacitance may perform impedance matching to the off-chip matching network while in the scan-only mode.

An aspect of the disclosure provides a radio-frequency amplifier. The radio-frequency amplifier can include a first cascode amplifier coupled between an input and an output of the radio-frequency amplifier. The radio-frequency amplifier can include a second cascode amplifier coupled between the input and the output in parallel with the first cascode amplifier. The radio-frequency amplifier can include a common source amplifier coupled between the input and the output in parallel with the first and second cascode amplifiers, wherein the radio-frequency amplifier is switchable between a first mode and a second mode, the first cascode amplifier is active and the common source amplifier is inactive while the radio-frequency amplifier is in the first mode, and the first cascode amplifier is inactive and the common source amplifier is active while the radio-frequency amplifier is in the second mode.

An aspect of the disclosure provides wireless circuitry. The wireless circuitry can include a radio-frequency transmission line path. The wireless circuitry can include a first low noise amplifier (LNA) communicatively coupled to the radio-frequency transmission line path. The wireless circuitry can include a second LNA communicatively coupled to the radio-frequency transmission line path, wherein the second LNA consumes less power than the first LNA, the first LNA and the second LNA are active while the wireless circuitry is in a first state, the first LNA is inactive and the second LNA is active while the wireless circuitry is in a second state, and the second LNA comprises matching circuitry that is configured to perform impedance matching to the radio-frequency transmission line path while the wireless circuitry is in the second state.

An aspect of the disclosure provides wireless circuitry. The wireless circuitry can include a substrate. The wireless circuitry can include a first receiver on the substrate and including a first amplifier. The wireless circuitry can include a second receiver on the substrate and including a second amplifier that is configured to scan for a signal that triggers activation of the first receiver, wherein the first amplifier is configured to perform impedance matching between the substrate and a matching network external to the substrate while the first receiver is active, the second amplifier comprises a common source inverter that includes a first transistor, a second transistor, a capacitor coupled to a first source-drain terminal of the first transistor and a second source-drain terminal of the second transistor, and switching circuitry, the switching circuitry switchably couples the capacitor to a gate terminal of the first capacitor and a gate terminal of the second capacitor, and the capacitor is configured to perform impedance matching between the substrate and the matching network while the first receiver is inactive.

### Brief Description of the Drawings

FIG. 1 is a diagram of an illustrative electronic device having wireless circuitry in accordance with some embodiments.
FIG. 2 is a diagram of illustrative wireless circuitry having radio-frequency amplifiers in accordance with some embodiments.
FIG. 3 is a diagram of illustrative wireless circuitry that includes a primary receiver and a scan receiver coupled to an antenna in accordance with some embodiments.
FIG. 4 is a block diagram of an illustrative scan low noise amplifier (SLNA) in a scan receiver in accordance with some embodiments.
FIG. 5 is a state diagram of illustrative operating modes for wireless circuitry that includes a primary receiver and a scan receiver in accordance with some embodiments.
FIG. 6 is a circuit diagram of an illustrative SLNA in accordance with some embodiments.
FIG. 7 includes plots illustrating the performance of an illustrative SLNA across process, voltage, and temperature corners in accordance with some embodiments.

### Detailed Description

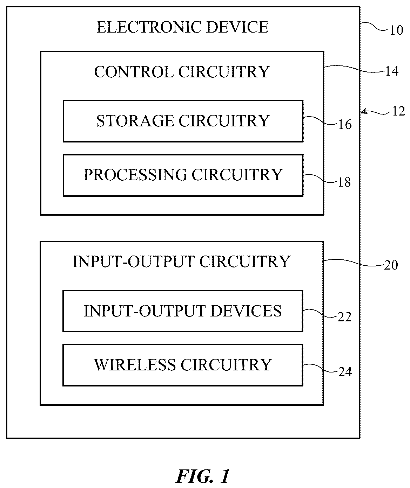

Electronic device 10 of FIG. 1 may be a computing device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses, goggles, a helmet, or other equipment worn on a user's head (e.g., an augmented, virtual, or mixed reality head-mounted display device), or another wearable or miniature device, a television, a computer display that does not contain an embedded computer, a gaming device, a navigation device, an embedded system such as a system in which electronic equipment with a display is mounted in a kiosk or automobile, a wireless internet-connected voice-controlled speaker, a home entertainment device, a remote control device, a gaming controller, a peripheral user input device, a wireless base station or access point, equipment that implements the functionality of two or more of these devices, or other electronic equipment.

As shown in the functional block diagram of FIG. 1, device 10 may include components located on or within an electronic device housing such as housing 12. Housing 12, which may sometimes be referred to as a case, may be formed from plastic, glass, ceramics, fiber composites, metal (e.g., stainless steel, aluminum, metal alloys, etc.), other suitable materials, or a combination of these materials. In some embodiments, parts or all of housing 12 may be formed from dielectric or other low-conductivity material (e.g., glass, ceramic, plastic, sapphire, etc.). In other embodiments, housing 12 or at least some of the structures that make up housing 12 may be formed from metal elements.

Device 10 may include control circuitry 14. Control circuitry 14 may include storage such as storage circuitry 16. Storage circuitry 16 may include hard disk drive storage, nonvolatile memory (e.g., flash memory or other electrically-programmable-read-only memory configured to form a solid-state drive), volatile memory (e.g., static or dynamic random-access-memory), etc. Storage circuitry 16 may include storage that is integrated within device 10 and/or removable storage media.

Control circuitry 14 may include processing circuitry such as processing circuitry 18. Processing circuitry 18 may be used to control the operation of device 10. Processing circuitry 18 may include on one or more processors such as microprocessors, microcontrollers, digital signal processors, host processors, baseband processor integrated circuits, application specific integrated circuits, central processing units (CPUs), graphics processing units (GPUs), etc. Control circuitry 14 may be configured to perform operations in device 10 using hardware (e.g., dedicated hardware or circuitry), firmware, and/or software. Software code for performing operations in device 10 may be stored on storage circuitry 16 (e.g., storage circuitry 16 may include non-transitory (tangible) computer readable storage media that stores the software code). The software code may sometimes be referred to as program instructions, software, data, instructions, or code. Software code stored on storage circuitry 16 may be executed by processing circuitry 18.

Control circuitry 14 may be used to run software on device 10 such as satellite navigation applications, internet browsing applications, voice-over-internet-protocol (VOIP) telephone call applications, email applications, media playback applications, operating system functions, etc. To support interactions with external equipment, control circuitry 14 may be used in implementing communications protocols. Communications protocols that may be implemented using control circuitry 14 include internet protocols, wireless local area network (WLAN) protocols (e.g., IEEE 802.11 protocols - sometimes referred to as Wi-Fi^{®}), protocols for other short-range wireless communications links such as the Bluetooth^{®} protocol or other wireless personal area network (WPAN) protocols, IEEE 802.11ad protocols (e.g., ultra-wideband protocols), cellular telephone protocols (e.g., 3G protocols, 4G (LTE) protocols, 3GPP Fifth Generation (5G) New Radio (NR) protocols, Sixth Generation (6G) protocols, sub-THz protocols, THz protocols, etc.), antenna diversity protocols, satellite navigation system protocols (e.g., global positioning system (GPS) protocols, global navigation satellite system (GLONASS) protocols, etc.), satellite communications (satcom) protocols, antenna-based spatial ranging protocols, optical communications protocols, or any other desired communications protocols. Each communications protocol may be associated with a corresponding radio access technology (RAT) that specifies the physical connection methodology used in implementing the protocol.

Device 10 may include input-output circuitry 20. Input-output circuitry 20 may include input-output devices 22. Input-output devices 22 may be used to allow data to be supplied to device 10 and to allow data to be provided from device 10 to external devices. Input-output devices 22 may include user interface devices, data port devices, and other input-output components. For example, input-output devices 22 may include touch sensors, displays (e.g., touch-sensitive and/or force-sensitive displays), light-emitting components such as displays without touch sensor capabilities, buttons (mechanical, capacitive, optical, etc.), scrolling wheels, touch pads, key pads, keyboards, microphones, cameras, buttons, speakers, status indicators, audio jacks and other audio port components, digital data port devices, motion sensors (accelerometers, gyroscopes, and/or compasses that detect motion), capacitance sensors, proximity sensors, magnetic sensors, force sensors (e.g., force sensors coupled to a display to detect pressure applied to the display), etc. In some configurations, keyboards, headphones, displays, pointing devices such as trackpads, mice, and joysticks, and other input-output devices may be coupled to device 10 using wired or wireless connections (e.g., some of input-output devices 22 may be peripherals that are coupled to a main processing unit or other portion of device 10 via a wired or wireless link).

Input-output circuitry 20 may include wireless circuitry 24 to support or perform radio-frequency signal transmission and/or reception for device 10. Wireless circuitry 24 may be used for wireless communications. Wireless communications performed by wireless circuitry 24 may include or involve wireless data communications (e.g., where wireless data is carried by radio-frequency signals conveyed between wireless circuitry 24 and other communications equipment bidirectionally or unidirectionally), radio-frequency signal transmission, radio-frequency signal reception, and/or radio-based spatial ranging/sensing (e.g., radio detection and ranging (radar) operations, shorter range object detection such as near-field radio-frequency signal-based object detection, etc.). Radio-frequency signals conveyed by wireless circuitry 24 may include or carry wireless data (e.g., organized into frames, packets, symbols, datagrams, etc.), radar or other spatial ranging waveforms, continuous wave signals, chirp signals, control signals, management signals, reference signals, beacon signals, tones, pulses/impulses, waveforms associated with one or more communications protocols, and/or any other radio-frequency waveforms or signals. Wireless circuitry 24 is sometimes also referred to herein as wireless communications circuitry 24, wireless communication circuitry 24, communications circuitry 24, or simply as circuitry 24. Wireless circuitry 24 may include one or more antennas. Wireless circuitry 24 may also include baseband processor circuitry, transceiver circuitry, amplifier circuitry, filter circuitry, switching circuitry, radio-frequency transmission lines, and/or any other circuitry for transmitting and/or receiving radio-frequency signals using the antenna(s). Some or all of the components of wireless circuitry 24 may be disposed on, mounted to, communicatively coupled to, and/or integrated within the same substrate (e.g., a printed circuit board, semiconductor substrate, chip, integrated circuit (IC), IC packages, etc.) or may be distributed between two or more substrates (e.g., printed circuit boards, semiconductor substrates, chips, ICs, IC packages, etc.).

Wireless circuitry 24 may transmit and/or receive radio-frequency signals within a corresponding frequency band at radio frequencies (sometimes referred to herein as a communications band or simply as a "band"). The frequency bands handled by wireless circuitry 24 may include wireless local area network (WLAN) frequency bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), a Wi-Fi^{®} 7 band, and/or other Wi-Fi^{®} bands (e.g., from 1875-5160 MHz), wireless personal area network (WPAN) frequency bands such as the 2.4 GHz Bluetooth^{®} band or other WPAN communications bands, cellular telephone frequency bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), other centimeter or millimeter wave frequency bands between 10-100 GHz, sub-THz frequency bands between around 100 GHz and 10 THz (e.g., 6G bands), near-field communications (NFC) frequency bands (e.g., at 13.56 MHz), satellite navigation frequency bands (e.g., a GPS band from 1565 to 1610 MHz, a Global Navigation Satellite System (GLONASS) band, a BeiDou Navigation Satellite System (BDS) band, etc.), ultra-wideband (UWB) frequency bands that operate under the IEEE 802.15.4 protocol and/or other ultra-wideband communications protocols, satellite communications (satcom) bands (e.g., an IEEE C band (4-8 GHz), S band (2-4 GHz), L band (1-2 GHz), X band (8-12 GHz), W band (75-110 GHz), V band (40-75 GHz), K band (18-27 GHz), Kₐ band (26.5-40 GHz), Kᵤ band (12-18 GHz), etc.), unlicensed bands, communications bands under the family of 3GPP wireless communications standards, communications bands under the IEEE 802.XX family of standards, and/or any other desired frequency bands of interest.

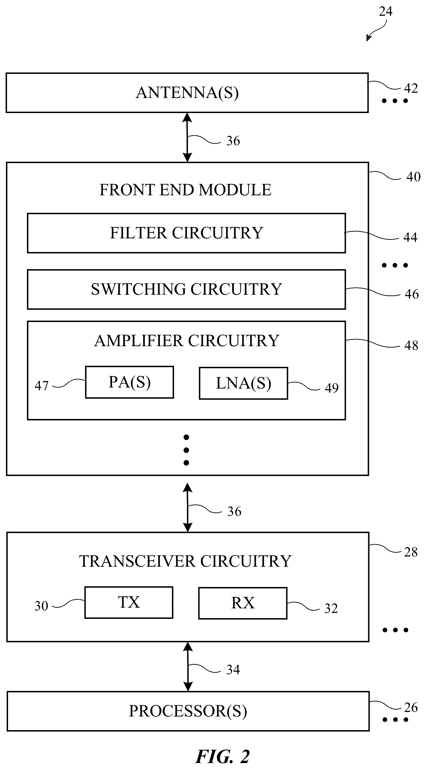

FIG. 2 is a diagram showing illustrative components within wireless circuitry 24. As shown in FIG. 2, wireless circuitry 24 may include a processor such as processor 26, radio-frequency (RF) transceiver circuitry such as radio-frequency transceiver 28, radio-frequency front end circuitry such as radio-frequency front end module (FEM) 40, and antenna(s) 42. Processor 26 may be a baseband processor, application processor, general purpose processor, microprocessor, microcontroller, digital signal processor, host processor, application specific signal processing hardware, or other type of processor. Processor 26 may be coupled to transceiver 28 over path 34. Transceiver 28 may be coupled to antenna 42 via radio-frequency transmission line path 36. Radio-frequency front end module 40 may be disposed on radio-frequency transmission line path 36 between transceiver 28 and antenna 42.

In the example of FIG. 2, wireless circuitry 24 is illustrated as including only a single processor 26, a single transceiver 28, a single front end module 40, and a single antenna 42 for the sake of clarity. In general, wireless circuitry 24 may include any desired number of processors 26, any desired number of transceivers 28, any desired number of front end modules 40, and any desired number of antennas 42. Each processor 26 may be coupled to one or more transceiver 28 over respective paths 34. Each transceiver 28 may include a transmitter circuit 30 configured to output uplink signals to antenna 42, may include a receiver circuit 32 configured to receive downlink signals from antenna 42, and may be coupled to one or more antennas 42 over respective radio-frequency transmission line paths 36. Each radio-frequency transmission line path 36 may have a respective front end module 40 disposed thereon. If desired, two or more front end modules 40 may be disposed on the same radio-frequency transmission line path 36. If desired, one or more of the radio-frequency transmission line paths 36 in wireless circuitry 24 may be implemented without any front end module disposed thereon.

Radio-frequency transmission line path 36 may be coupled to an antenna feed on antenna 42. The antenna feed may, for example, include a positive antenna feed terminal and a ground antenna feed terminal. Radio-frequency transmission line path 36 may have a positive transmission line signal path that is coupled to the positive antenna feed terminal on antenna 42. Radio-frequency transmission line path 36 may have a ground transmission line signal path that is coupled to the ground antenna feed terminal on antenna 42. This example is illustrative and, in general, antennas 42 may be fed using any desired antenna feeding scheme. If desired, antenna 42 may have multiple antenna feeds that are coupled to one or more radio-frequency transmission line paths 36.

Radio-frequency transmission line path 36 may include transmission lines that are used to route radio-frequency antenna signals within device 10 (FIG. 1). Transmission lines in device 10 may include coaxial cables, microstrip transmission lines, stripline transmission lines, edge-coupled microstrip transmission lines, edge-coupled stripline transmission lines, transmission lines formed from combinations of transmission lines of these types, etc. Transmission lines in device 10 such as transmission lines in radio-frequency transmission line path 36 may be integrated into rigid and/or flexible printed circuit boards.

In performing wireless transmission, processor 26 may provide transmit signals (e.g., digital or baseband signals) to transceiver 28 over path 34. Transceiver 28 may further include circuitry for converting the transmit (baseband) signals received from processor 26. For example, transceiver circuitry 28 may include mixer circuitry for up-converting (or modulating) the transmit (baseband) signals to radio frequencies prior to transmission over antenna 42. The example of FIG. 2 in which processor 26 communicates with transceiver 28 is illustrative. In general, transceiver 28 may communicate with a baseband processor, an application processor, general purpose processor, a microcontroller, a microprocessor, or one or more processors within circuitry 18. Transceiver circuitry 28 may also include digital-to-analog converter (DAC) and/or analog-to-digital converter (ADC) circuitry for converting signals between digital and analog domains. Transceiver 28 may use transmitter (TX) 30 to transmit the radio-frequency signals over antenna 42 via radio-frequency transmission line path 36 and front end module 40. Antenna 42 may transmit the radio-frequency signals to external wireless equipment by radiating the radio-frequency signals into free space.

In performing wireless reception, antenna 42 may receive radio-frequency signals from the external wireless equipment. The received radio-frequency signals may be conveyed to transceiver 28 via radio-frequency transmission line path 36 and front end module 40. Transceiver 28 may include circuitry such as receiver (RX) 32 for receiving signals from front end module 40 and for converting the received radio-frequency signals into corresponding baseband signals. For example, transceiver 28 may include mixer circuitry for down-converting (or demodulating) the received radio-frequency signals to baseband frequencies prior to conveying the received signals to processor 26 over path 34.

Front end module (FEM) 40 may include radio-frequency front end circuitry that operates on the radio-frequency signals conveyed (transmitted and/or received) over radio-frequency transmission line path 36. FEM 40 may, for example, include front end module (FEM) components such as radio-frequency filter circuitry 44 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), radio-frequency amplifier circuitry 48 (e.g., one or more power amplifiers 47 and/or one or more low-noise amplifier circuits 49), signal attenuators, impedance matching circuitry (e.g., circuitry that helps to match the impedance of antenna 42 to the impedance of radio-frequency transmission line 36), antenna tuning circuitry (e.g., networks of capacitors, resistors, inductors, and/or switches that adjust the frequency response of antenna 42), radio-frequency coupler circuitry, charge pump circuitry, power management circuitry, digital control and interface circuitry, and/or any other desired circuitry that operates on the radio-frequency signals transmitted and/or received by antenna 42. Each of the front end module components may be mounted to a common (shared) substrate such as a rigid printed circuit board substrate or flexible printed circuit substrate. If desired, the various front end module components may also be integrated into a single integrated circuit chip. If desired, amplifier circuitry 48 and/or other components in front end 40 such as filter circuitry 44 may also be implemented as part of transceiver circuitry 28.

Filter circuitry 44, switching circuitry 46, amplifier circuitry 48, and other circuitry may be disposed along radio-frequency transmission line path 36, may be incorporated into FEM 40, and/or may be incorporated into antenna 42 (e.g., to support antenna tuning, to support operation in desired frequency bands, etc.). These components, sometimes referred to herein as antenna tuning components, may be adjusted (e.g., using control circuitry 14) to adjust the frequency response and wireless performance of antenna 42 over time.

Transceiver 28 may be separate from front end module 40. For example, transceiver 28 may be formed on another substrate such as the main logic board of device 10, a rigid printed circuit board, or flexible printed circuit that is not a part of front end module 40. While control circuitry 14 is shown separately from wireless circuitry 24 in the example of FIG. 1 for the sake of clarity, wireless circuitry 24 may include processing circuitry that forms a part of processing circuitry 18 and/or storage circuitry that forms a part of storage circuitry 16 of control circuitry 14 (e.g., portions of control circuitry 14 may be implemented on wireless circuitry 24). As an example, processor 26 and/or portions of transceiver 28 (e.g., a host processor on transceiver 28) may form a part of control circuitry 14. Control circuitry 14 (e.g., portions of control circuitry 14 formed on processor 26, portions of control circuitry 14 formed on transceiver 28, and/or portions of control circuitry 14 that are separate from wireless circuitry 24) may provide control signals (e.g., over one or more control paths in device 10) that control the operation of front end module 40.

Transceiver 28 may include wireless local area network transceiver circuitry that handles WLAN communications bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network transceiver circuitry that handles the 2.4 GHz Bluetooth^{®} band or other WPAN communications bands, cellular telephone transceiver circuitry that handles cellular telephone bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, 6G bands above 100 GHz, etc.), near-field communications (NFC) transceiver circuitry that handles near-field communications bands (e.g., at 13.56 MHz), satellite navigation receiver circuitry that handles satellite navigation bands (e.g., a GPS band from 1565 to 1610 MHz, a Global Navigation Satellite System (GLONASS) band, a BeiDou Navigation Satellite System (BDS) band, etc.), ultra-wideband (UWB) transceiver circuitry that handles communications using the IEEE 802.15.4 protocol and/or other ultra-wideband communications protocols, and/or any other desired radio-frequency transceiver circuitry for covering any other desired communications bands of interest.

Wireless circuitry 24 may include one or more antennas such as antenna 42. Antenna 42 may be formed using any desired antenna structures. For example, antenna 42 may be an antenna with a resonating element that is formed from loop antenna structures, patch antenna structures, inverted-F antenna structures, slot antenna structures, planar inverted-F antenna structures, helical antenna structures, monopole antennas, dipoles, hybrids of these designs, etc. Two or more antennas 42 may be arranged into one or more phased antenna arrays (e.g., for conveying radio-frequency signals at millimeter wave frequencies). Parasitic elements may be included in antenna 42 to adjust antenna performance. Antenna 42 may be provided with a conductive cavity that backs the antenna resonating element of antenna 42 (e.g., antenna 42 may be a cavity-backed antenna such as a cavity-backed slot antenna).

The receiver(s) 32 in transceiver circuitry 28 may include radio-frequency low noise amplifiers (LNAs) for amplifying radio-frequency signals received by a corresponding antenna 24. If desired, transceiver circuitry 28 may include multiple receivers 32 that are communicatively coupled to the same antenna 42 for receiving radio-frequency signals via that antenna 42. In implementations that are described herein as an example, transceiver 28 may include both a primary receiver and a scan receiver that are communicatively coupled to a given antenna 42.

The primary receiver consumes more power than the scan receiver and may be used to perform high performance/quality wireless data reception via the antenna (e.g., reception of wireless data frames, packets, symbols, etc.). The scan receiver may be used to scan for radio-frequency signals suitable for reception by the primary receiver (e.g., may receive radio-frequency energy and may scan for radio-frequency signals in the radio-frequency energy while sweeping through different frequencies until a radio-frequency signal carrying wireless data for reception by the primary receiver is found, detected, decoded, and/or received). If desired, the primary receiver may be asleep, idle, inactive, powered down, powered off, or switched off while the scan receiver scans for radio-frequency signals to help conserve power in device 10. Because the scan receiver is used to scan for a radio-frequency signal carrying wireless data and is not used to receive the wireless data on its own (e.g., without the primary receiver also being active), the scan receiver can consume less total power, chip area, and/or other resources in device 10 than the primary receiver without sacrificing wireless communications quality.

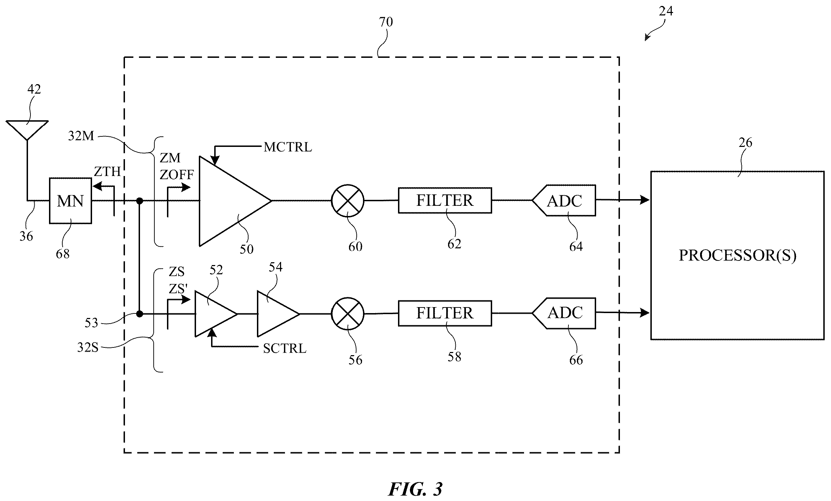

FIG. 3 is a diagram showing an example in which wireless circuitry 24 includes a primary receiver and a secondary receiver for receiving radio-frequency signals via a corresponding antenna 42. As shown in FIG. 3, wireless circuitry 24 may include a first receiver 32 such as primary receiver 32M and a second receiver 32 such as scan receiver 32S that are each communicatively coupled to the same antenna 42 (e.g., over a corresponding radio-frequency transmission line path 36). Primary receiver 32M is sometimes also referred to herein as primary receiver path 32M, primary receiver chain 32M, primary receive path 32M, primary receive chain 32M, or main receiver 32M. Scan receiver 32S is sometimes also referred to herein as scan receiver path 32S, scan receiver chain 32S, scan receive path 32S, scan receive chain 32S, or secondary receiver 32S. Scan receiver 32S may consume less total/peak power and/or other resources than primary receiver 32M.

Primary receiver 32M and scan receiver 32S may be coupled in parallel between radio-frequency transmission line path 36 and one or more processors 26. Impedance matching circuitry such as matching network (MN) 68 may be disposed on radio-frequency transmission line path 46 between antenna 68 and the receivers. Primary receiver 32M may include one or more low noise amplifiers (LNAs) such as primary LNA 50 (sometimes also referred to herein as main LNA 50), downconversion circuitry such as one or more mixers 60, filtering circuitry such as filter 62 (e.g., a bandpass filter, notch filter, low pass filter, attenuator, etc.), and conversion circuitry such as analog-to-digital converter (ADC) 64. The input of primary LNA 50 may be coupled to radio-frequency transmission line path 36. Mixer 60 may be coupled between the output of primary LNA 50 and the input of filter 62. Filter 62 may be coupled between the output of mixer 60 and the input of ADC 64. The output of ADC 64 may be coupled to processor(s) 26.

Scan receiver 32S may include one or more low noise amplifiers such as scan LNA 52 (sometimes also referred to herein as secondary LNA 52). If desired, scan receiver 32S may also include buffer circuitry such as buffer 54. Scan receiver 32S may further include downconversion circuitry such as one or more mixers 56, filtering circuitry such as filter 58 (e.g., a bandpass filter, notch filter, low pass filter, attenuator, etc.), and conversion circuitry such as ADC 66. The input of scan LNA 52 may be coupled to radio-frequency transmission line path 36 (e.g., at a node on radio-frequency transmission line path 36 between matching network 68 and primary LNA 50). Buffer 54 may be coupled between the output of scan LNA 52 and the input of mixer 56. Mixer 56 may be coupled between the output of buffer 54 and the input of filter 58. Filter 58 may be coupled between the output of mixer 56 and the input of ADC 66. The output of ADC 66 may be coupled to processor(s) 26. If desired, additional circuit components (not shown) may be disposed within primary receiver 32M and/or scan receiver 32S and/or some of the components in one or both receivers may be omitted.

During signal reception, antenna 42 may pass incident radio-frequency signals onto radio-frequency transmission line path 36 (e.g., while matching network 68 matches the impedance of radio-frequency transmission line path 36 to the impedance of antenna 42 at the frequencies of the radio-frequency signals). Primary LNA 50 may amplify the incident radio-frequency signal (e.g., based on a control signal MCTRL that controls the gain and/or other characteristics of primary LNA 50). Control signal MCTRL may include one or more bias voltages (e.g., power supply voltages), load-line modulation control signals, switch control signals, and/or other control signals. Mixer 60 may downconvert the amplified radio-frequency signals to baseband (or to an intermediate frequency that is then downconverted to baseband by an additional mixer). Filter 62 may filter out unwanted frequencies from the downconverted signal. ADC 64 may convert the downconverted signal from the analog domain to the digital domain (e.g., as a digital stream of baseband bits or other digital data representing the wireless data carried by the incident radio-frequency signals). As examples, the digital signal output by ADC 64 may include in-phase (I) and quadrature-phase (Q) signals, radius and phase signals, a vector input, or other digitally coded signals.

Scan LNA 52 and buffer 54 may also amplify the radio-frequency signals on radio-frequency transmission line path 36. Scan LNA 52 may amplify the radio-frequency signals based on a corresponding control signal SCTRL that controls the gain and/or other characteristics of scan LNA 52. Control signal SCTRL may include one or more bias voltages (e.g., power supply voltages), load-line modulation control signals, switch control signals, and/or other control signals. Mixer 56 may downconvert the amplified radio-frequency signals to baseband (or to an intermediate frequency that is then downconverted to baseband by an additional mixer). Filter 58 may filter out unwanted frequencies from the downconverted signal. ADC 66 may convert the downconverted signal from the analog domain to the digital domain.

Processor(s) 26 may represent one or more processors such as a baseband processor, an application processor, a digital signal processor, a microcontroller, a microprocessor, a central processing unit (CPU), a programmable device, a combination of these circuits, and/or one or more processors within circuitry 18 of FIG. 1. Processor(s) 26 may perform any desired operations based on the digital data output by ADC 64 and/or ADC 66. In some implementations that are described herein as an example, scan receiver 32S may serve as a scan or wakeup receiver for primary receiver 32M. Scan receiver 32S may receive radio-frequency signals while primary receiver 32M is powered down, idle, asleep, inactive, or powered off. Scan receiver 32S may scan incident radio-frequency energy for a signal (e.g., a data signal) that requires reception by primary receiver 32M to be received with a satisfactory level of performance. Processor(s) 26 may process digital data output by ADC 66 and, in response to detecting suitable data in the incident radio-frequency signals, may wake, power up, turn on, and/or otherwise activate primary receiver 32M. Once active, primary receiver 32M may be used to receive the radio-frequency signals and to pass wireless data from the radio-frequency signals to processor(s) 26. If desired, scan receiver 32S may remain active while primary receiver 32M is active (e.g., in a coexistence mode of wireless circuitry 24).

If desired, both primary receiver 32M and secondary receiver 32S may be disposed on and/or integrated within a corresponding substrate 70. Substrate 70 may be an integrated circuit (IC) chip (e.g., primary receiver 32M and secondary receiver 32S may be implemented on the same IC chip or IC package), a package substrate, a printed circuit board, etc. Processor(s) 26 may be separate from (e.g., external to) substrate 70 or may be integrated into substate 70 if desired. Matching network 68 is external to substrate 70 and is therefore sometimes also referred to herein as off-chip matching network 68. If desired, substrate 70 may be a substrate of FEM 40 (FIG. 2) (e.g., receivers 32M and 32S may be integrated into FEM 40 if desired) or may be separate from FEM 40.

Matching network 68 may exhibit an impedance ZTH (e.g., as viewed from the perspective of primary receiver 32M and secondary receiver 32S). When primary receiver 32M is active (e.g., in a coexistence mode of wireless circuitry 24), primary LNA 50 may exhibit an input impedance ZM. When primary receiver 32M is inactive (e.g., in a scan mode of wireless circuitry 24), primary LNA 50 may exhibit an input impedance ZOFF. When scan receiver 32S and primary receiver 32M are both active (e.g., in the coexistence mode of wireless circuitry 24), scan LNA 52 may exhibit an input impedance ZS. When scan receiver 32S is active and primary receiver 32M is inactive (e.g., in the scan mode of wireless circuitry 24), scan LNA 52 may exhibit an input impedance ZS'.

A receiver 32 such as primary receiver 32M or secondary receiver 32S is referred to herein as being "active," "activated," "powered on," "enabled," "turned on," "switched on," or "on" when that receiver is switched or coupled into use between radio-frequency transmission line 36 and processor(s) 26, such that the receiver receives and converts radio-frequency energy on radio-frequency transmission line path 36 into digital data that is provided to processor(s) 26. When a receiver is active, the LNA(s) in that receiver are active, powered on, and/or switched into use (e.g., the LNA(s) amplify radio-frequency energy incident upon the receiver and pass the amplified radio-frequency energy to the corresponding mixer for downconversion). Conversely, a receiver 32 such as primary receiver 32M or secondary receiver 32S is referred to herein as being "inactive," "deactivated," "powered off," "disabled," "turned off," "switched off," or "off" when that receiver is switched out of use (decoupled) between radio-frequency transmission line 36 and processor(s) 26 (e.g., forming an open circuit or infinite impedance between the radio-frequency transmission line path and the processor(s)), such that the receiver does not receive and/or convert radio-frequency energy into digital data that is provided to processor(s) 26. When a receiver is off, LNA(s) in that receiver are inactive, powered off, and/or switched out of use (e.g., the LNA(s) do not amplify radio-frequency energy incident upon the receiver and do not pass signals to the corresponding mixer). A receiver 32 such as primary receiver 32M may also be operable in a "sleep," "idle," or "standby" mode in which components of the receiver receives some power (e.g., is not completely powered off) but is not fully powered, does not actively receive radio-frequency signals, and/or does not actively pass corresponding digital data to processor(s) 26. In general, a receiver may consume more power when in an "on" state than in a "sleep" state and consumes more power in a "sleep" state than in an "off" state.

Scan receiver 32S may allow wireless circuitry 24 to reduce DC power consumption when a higher performance receiver in wireless circuitry 24 (e.g., primary receiver 32M) is not otherwise needed. In practice, it can be challenging to implement a lower power/performance receiver in wireless circuitry 24 (e.g., scan receiver 32S) while still maintaining sufficient isolation, noise figure (NF), and linearity. In some implementations, wireless circuitry 24 achieves these goals at least by using an additional matching network on substrate 70 and external to scan LNA 52 (e.g., an adjustable resistive termination coupled between node 53 and ground), which helps to ensure that the receivers remain suitably matched to the impedance ZTH of matching network 68 across operating modes.

In these implementations, the adjustable resistive termination is switched into use when both primary receiver 32M and scan receiver 32S are active (e.g., in the coexistence mode) and is switched out of use when primary receiver 32M is inactive and receiver 32S is active (e.g., in the scan mode). When both primary receiver 32M and scan receiver 32S are active, the circuitry of primary LNA 50 performs sufficient impedance matching with matching network 68, such that the resistive termination coupled to node 53 has minimal effect on the impedance matching of substrate 70 to matching network 68. On the other hand, when primary receiver 32M is inactive and scan receiver 32S is active (e.g., in the scan mode), the resistive termination performs impedance matching between substrate 70 and matching network 68. However, the inclusion of additional matching circuitry such as an adjustable resistive termination coupled to node 53 limits the performance of wireless circuitry 24 because resistor(s) in the adjustable resistive termination add additional noise to the received signal on top of noise imparted to the signal by the LNA(s) themselves. This can cause the received signals to be excessively noisy and can deteriorate the NF of wireless circuitry 24. To mitigate these issues (e.g., to perform suitable impedance matching between substrate 70 and matching network 68 across operating modes), scan LNA 52 may be configured to perform impedance matching between substrate 70 and matching network 68 itself, allowing external resistive terminations at node 53 to be omitted from substrate 70. This can serve to reduce the overall noise imparted to received signals and can improve the NF of wireless circuitry 24.

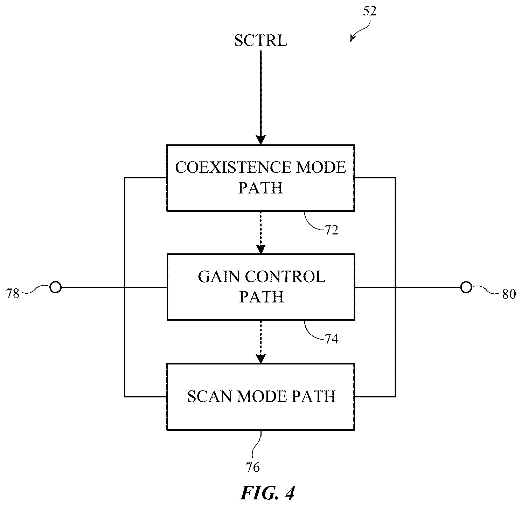

FIG. 4 is a schematic block diagram of scan LNA 52. As shown in FIG. 4, scan LNA 52 may include a coexistence mode path 72, a gain control path 74, and a scan mode path 76 coupled in parallel between an input 78 and an output 80 of scan LNA 52. Input 78 is sometimes also referred to herein as input terminal 78 or input port 78 of scan LNA 52. Output 80 is sometimes also referred to herein as output terminal 80 or output port 80 of scan LNA 52. Coexistence mode path 72 is sometimes also referred to herein as coexistence mode circuitry 72, coexistence path 72, or coexistence mode amplifier 72. Scan mode path 76 is sometimes also referred to herein as scan mode circuitry 76, scan path 76, or scan mode amplifier 76. Gain control path 74 is sometimes also referred to herein as gain control circuitry 74 or gain control amplifier 74.

Control signal SCTRL may selectively activate one or more of paths 72-76 at a given time (e.g., depending on the present operating mode of scan LNA 52). A path between input 78 and output 80 is referred to herein as being "active," "activated," "turned on," "switched on," or "enabled" when the path is switched into use between input 78 and output 80 and/or when signals pass through the path from input 78 to output 80 (e.g., input 78 may be communicatively coupled to output 80 through the active path(s) of scan LNA 52). A path between input 78 and output 80 is referred to herein as being "inactive," "deactivated," "turned off," "switched off," or "disabled" when the path is switched out of use between input 78 and output 80 and/or when signals do not pass through the path from input 78 to output 80 (e.g., input 78 may be decoupled from output 80 through the inactive path(s) of scan LNA 52 and the inactive path(s) may exhibit infinite or open circuit impedances between the input and output of the scan LNA).

Control signal SCTRL may, for example, include one or more control signals that control the state of switching circuitry in one or more of paths 72-76 to activate or deactivate that path. Control signal SCTRL may also include one or more bias voltages (e.g., power supply voltages) provided to different components within paths 72-76. The bias voltages may be asserted or applied to the active paths of scan LNA 52. If desired, the bias voltages may be decoupled from the inactive paths in scan LNA 52 or may be provided at relatively low magnitudes (e.g., zero volts, less than a threshold voltage, etc.).

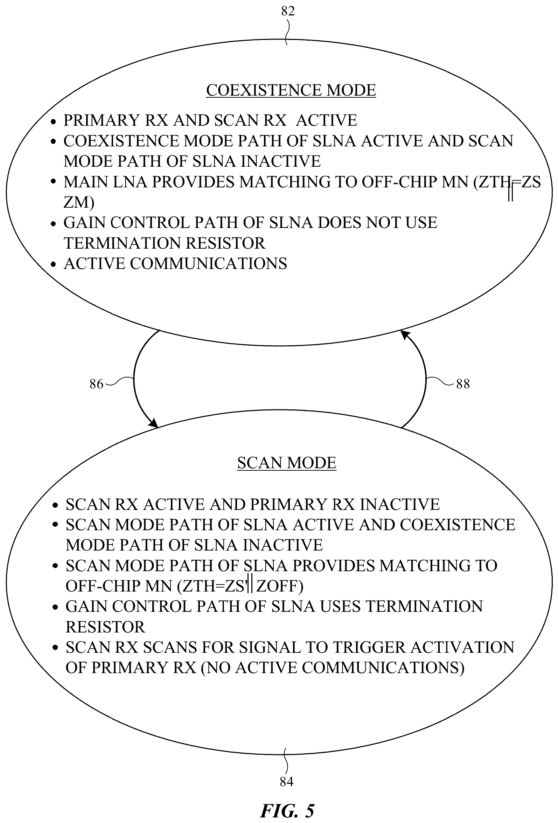

FIG. 5 is a state diagram showing two illustrative operating modes (states) of wireless circuitry 24 (sometimes also referred to herein as operating modes (states) of scan LNA 52, primary LNA 50, scan receiver 32S, and/or primary receiver 32M). As shown in FIG. 5, wireless circuitry 24 may be operable in at least a first mode such as coexistence mode (state) 82 and a second mode such as scan mode (state) 84. Scan mode 84 is sometimes also referred to as scan-only mode 84.

In coexistence mode 82, primary receiver 32M and its primary LNA 50 are active. Secondary receiver 32S and its scan LNA 52 are also active, concurrent with primary receiver 32M and primary LNA 50 being active. Within scan LNA 52, coexistence mode path 72 (FIG. 4) is active and is used to amplify radio-frequency signals incident from radio-frequency transmission line path 36. At the same time, the scan mode path 76 of scan LNA 52 is inactive. Primary LNA 50 exhibits input impedance ZM and scan LNA 52 exhibits input impedance ZS. Because input impedance ZS is high in this mode, it does not substantively affect input matching of substrate 70 to matching network 68. As such, circuitry within primary LNA 50 matches the impedance of matching network 68 (e.g., primary LNA 50 performs impedance matching with matching network 68 itself while in the coexistence mode, where ZTH = ZS ∥ ZM).

Gain control path 74 of scan LNA 52 may perform gain control for scan LNA 52 while active. In coexistence mode 82, a termination resistor of gain control path 74 may be inactive or switched out of use. Both primary receiver 32M and scan receiver 32S may receive radio-frequency signals via antenna 42 and radio-frequency transmission line path 36, may generate corresponding digital data from the received radio-frequency signals, and may pass the digital data to processor(s) 26. Wireless circuitry 24 may exhibit a high enough level of performance to support active communications between device 10 and an external device that transmitted the radio-frequency signals while wireless circuitry 24 is in the coexistence mode (e.g., due to primary receiver 32M actively receiving radio-frequency signals). These communications may also involve the transmission of wireless data to the external device (e.g., by one or more transmitters 30 of FIG. 2).

On the other hand, in scan mode 84, primary receiver 32M and its primary LNA 50 are inactive while secondary receiver 32S and its scan LNA 52 are active. Primary receiver 32M may be asleep, powered down, turned off, or switched off, as examples. This may help to conserve power in device 10. The scan mode path 76 of scan LNA 52 is active and is used to amplify radio-frequency energy incident from radio-frequency transmission line path 36. At the same time, the coexistence mode path 72 of scan LNA 52 is inactive. Primary LNA 50 exhibits input impedance ZOFF and scan LNA 52 exhibits input impedance ZS'. Rather than utilizing an additional resistive termination external to scan LNA 52 to perform impedance matching between the receivers and matching network 68 while primary LNA 50 is inactive, circuitry within scan LNA 52 matches the impedance of matching network 68 on its own (e.g., scan LNA 52 performs impedance matching with matching network 68, where ZTH = ZS' ∥ ZOFF).

Gain control path 74 of scan LNA 52 may perform gain control for scan LNA 52 while active. In scan mode 84, the termination resistor of gain control path 74 may be active or switched into use if desired. Scan receiver 32S (but not primary receiver 32M) may receive radio-frequency signals via antenna 42 and radio-frequency transmission line path 36, may generate corresponding digital data from the received radio-frequency signals, and may pass the digital data to processor(s) 26.

Wireless circuitry 24 may exhibit an insufficient level of performance to support active communications between device 10 and an external device while wireless circuitry 24 is in the scan mode (e.g., due to primary receiver 32M being inactive). However, scan LNA 52 still amplifies incident radio-frequency energy and generates corresponding digital data that is passed to processor(s) 26. Processor(s) 26 may process the digital data to detect (e.g., search for) a radio-frequency signal that carries wireless data, a beacon signal, a control signal, a management signal, and/or any other desired signal that triggers the activation of primary receiver 32M. When such a signal is detected by processor(s) 26 from the digital data output by scan receiver 32S (or in response to any other desired trigger condition), processor(s) 26 may control wireless circuitry 24 to transition or switch from scan mode 84 to coexistence mode 82 as shown by arrow 88. When in coexistence mode 82, processor(s) 26 may transition or switch wireless circuitry 24 from coexistence mode 82 back to scan mode 84 (as shown by arrow 86) after a sufficient amount of time has elapsed without reception of wireless data and/or in response to any desired trigger condition.

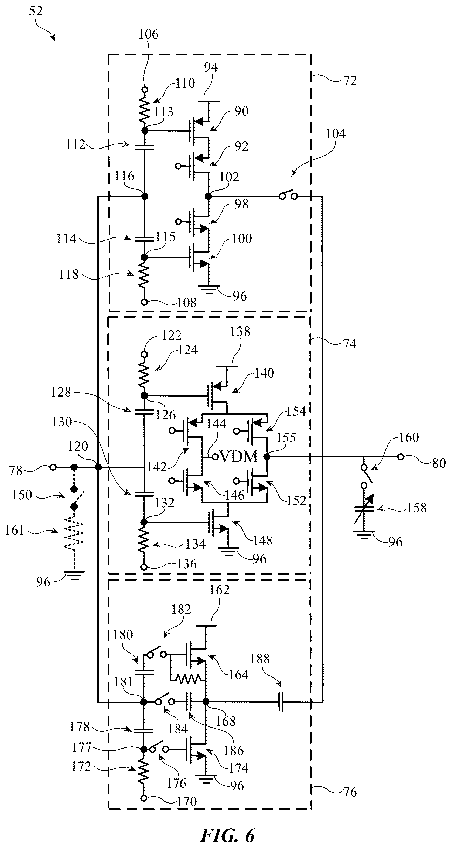

FIG. 6 is a circuit diagram of scan LNA 52. As shown in FIG. 6, coexistence mode path 72, gain control path 74, and scan mode path 76 may be coupled in parallel between input 78 and output 80 of scan LNA 52. In the example of FIG. 6, coexistence mode path 72 is implemented as a complimentary metal-oxide-semiconductor (CMOS) cascode amplifier. The cascode amplifier has a common gate stage that includes a first transistor 92 (e.g., a p-channel metal-oxide-semiconductor (PMOS) transistor) and a second transistor 98 (e.g., an n-channel metal-oxide-semiconductor (NMOS) transistor), collectively forming complementary pair of PMOS and NMOS transistors. The cascode amplifier also has a common source stage that includes a first transistor 90 (e.g., a PMOS transistor) and a second transistor 100 (e.g., an NMOS transistor), collectively forming a complimentary pair of PMOS and NMOS transistors. The common source stage may drive/feed the common gate stage of the cascode amplifier. A circuit node 102 between transistors 92 and 98 of the common gate stage may be communicatively (e.g., switchably) coupled to output 80 of scan LNA 52 by switching circuitry such as switch 104.

The terms "source" and "drain" terminals used to refer to current-conveying terminals in a transistor may be used interchangeably and are sometimes referred to as "source-drain" terminals. Thus, the source terminal of the first transistor can thus sometimes be referred to as a first source-drain terminal, and the drain terminal of the first transistor can be referred to as a second source-drain terminal (or vice versa). Switch/transistor control signals (voltages) may be applied to gate terminals of transistors to control the switch states of the transistors (e.g., to activate or deactivate the transistors).

The term "activate" with respect to a switch (or transistor) may refer to or be defined herein as an action that places the switch (or transistor) in an "on" or low-impedance state such that the two source-drain terminals of the switch are electrically connected to conduct current. Activating a switch can sometimes be referred to as turning on, enabling, or closing a switch (e.g., an active switch is sometimes also referred to herein as an on switch, an enabled switch, or a closed switch). The term "deactivate" with respect to a switch (or transistor) may refer to or be defined herein as an action that places the switch (or transistor) in an "off" or high-impedance state such that the two source-drain terminals of the switch/transistor are electrically disconnected with minimal leakage current. Deactivating a switch can sometimes be referred to as turning off, disabling, or opening a switch (e.g., a deactivated switch is sometimes also referred to herein as an off switch, a disabled switch, or an open switch).

As shown in FIG. 6, the first source-drain terminal (e.g., source terminal) of transistor 90 may be coupled to bias terminal 94 (e.g., a power supply voltage terminal or rail of scan LNA 52 that receives a power supply voltage from power supply circuitry in device 10). The second source-drain terminal (e.g., drain terminal) of transistor 90 may be coupled to the first source-drain terminal (e.g., source terminal) of transistor 92 (e.g., transistor 90 may be coupled between transistor 92 and bias terminal 94). The gate terminal of transistor 90 may be coupled to circuit node 113 of coexistence mode path 72. The second source-drain terminal (e.g., drain terminal) of transistor 92 may be coupled to circuit node 102 (e.g., transistor 92 may be coupled between transistor 90 and circuit node 102).

The first source-drain terminal (e.g., source terminal) of transistor 100 may be coupled to reference voltage 96 (e.g., a ground voltage or another reference potential). The second source-drain terminal (e.g., drain terminal) of transistor 100 may be coupled to the first source-drain terminal (e.g., source terminal) of transistor 98 (e.g., transistor 100 may be coupled between transistor 98 and reference voltage 96). The gate terminal of transistor 100 may be coupled to circuit node 115 of coexistence mode path 72. The second source-drain terminal (e.g., drain terminal) of transistor 98 may be coupled to circuit node 102 and the second source-drain terminal of transistor 92 (e.g., transistor 98 be coupled between transistor 100 and circuit node 102). The gate terminals of the common gate stage (transistors 92 and 98) may receive a corresponding bias voltage (e.g., a common source stage control voltage). Circuit node 102 may be coupled to switch 104. Switch 104 may couple circuit node 102 to output 80 of scan LNA 52.

Coexistence mode path 72 may also include a first resistance 110 (e.g., one or more resistors), a second resistance 118 (e.g., one or more resistors), a first capacitance 112 (e.g., one or more capacitors), and a second capacitance 114 (e.g., one or more capacitors). Resistance 110 may couple circuit node 113 to bias terminal 106. Capacitance 112 may couple circuit node 113 to circuit node 116. Circuit node 116 may be communicatively coupled to input 78 of scan LNA 52 (e.g., via an additional circuit node such as circuit node 120). Capacitance 114 may couple circuit node 116 to circuit node 115. Resistance 118 may couple circuit node 115 to bias terminal 108. Bias terminal 106 and bias terminal 108 may receive one or more bias voltages (e.g., different than the bias voltage supplied to bias terminal 94).

In the example of FIG. 6, gain control path 74 is also implemented using a CMOS cascode amplifier. The cascode amplifier may have a common source stage that includes a first transistor 140 (e.g., a PMOS transistor) and a second transistor 148 (e.g., an NMOS transistor), collectively forming complementary pair of PMOS and NMOS transistors. The cascode amplifier may also have first and second common gate stages coupled in parallel between transistors 140 and 148 of the common source stage. The first common gate stage may include a first transistor 142 (e.g., a PMOS transistor) and a second transistor 146 (e.g., an NMOS transistor), collectively forming a complimentary pair of PMOS and NMOS transistors. The second common gate stage may include a first transistor 154 (e.g., a PMOS transistor) and a second transistor 152 (e.g., an NMOS transistor), collectively forming a complimentary pair of PMOS and NMOS transistors. During operation, a dummy voltage VDM may be produced at terminal 144 between transistors 142 and 146. Terminal 144 may be floating or may be coupled to other fixed circuitry. A circuit node 155 between transistors 154 and 152 may be coupled to output 80 of scan LNA 52. The common source stage may drive/feed the common gate stages of the cascode amplifier.

The first source-drain terminal (e.g., source terminal) of transistor 140 may be coupled to bias terminal 138 (e.g., a power supply voltage terminal or rail of scan LNA 52 that receives a power supply voltage from power supply circuitry in device 10). The second source-drain terminal (e.g., drain terminal) of transistor 140 may be coupled to the first source-drain terminal (e.g., source terminal) of transistor 142 and the first source-drain terminal (e.g., source terminal) of transistor 154 (e.g., transistor 140 may be coupled between transistors 142 and 154 and bias terminal 138). The gate terminal of transistor 140 may be coupled to circuit node 126 of gain control path 74. The second source-drain terminal (e.g., drain terminal) of transistor 142 may be coupled to terminal 144. The second source-drain terminal (e.g., drain terminal) of transistor 154 may be coupled to circuit node 155.

The first source-drain terminal (e.g., source terminal) of transistor 148 may be coupled to reference voltage 96. The second source-drain terminal (e.g., drain terminal) of transistor 148 may be coupled to the first source-drain terminal (e.g., source terminal) of transistor 146 and to the first source-drain terminal (e.g., source terminal) of transistor 152 (e.g., transistor 148 may be coupled between transistors 146 and 152 and reference voltage 96). The gate terminal of transistor 148 may be coupled to circuit node 132 of coexistence mode path 72. The second source-drain terminal (e.g., drain terminal) of transistor 146 may be coupled to terminal 144 and the second source-drain terminal of transistor 142. The second source-drain terminal (e.g., drain terminal) of transistor 152 may be coupled to circuit node 155 and the second source-drain terminal of transistor 154. The gate terminals of the common source stages (transistors 142, 146, 154, and 152) may receive a corresponding bias voltage (e.g., a common source stage control voltage).

Gain control path 74 may also include a first resistance 124 (e.g., one or more resistors), a second resistance 134 (e.g., one or more resistors), a first capacitance 128 (e.g., one or more capacitors), and a second capacitance 130 (e.g., one or more capacitors). Resistance 124 may couple circuit node 126 to bias terminal 122. Capacitance 128 may couple circuit node 126 to circuit node 120. Circuit node 120 may be coupled to input 78 of scan LNA 52. Capacitance 130 may couple circuit node 120 to circuit node 132. Resistance 134 may couple circuit node 132 to bias terminal 136. Bias terminal 122 and bias terminal 136 may receive one or more bias voltages (e.g., different than the bias voltage supplied to bias terminal 138).

The common source stage may control gain of the scan LNA by steering current within the gain control path. The cascode amplifier of gain control path 74 may exhibit reduced current to achieve gain control for scan LNA 52. The cascode amplifier of gain control path 74 may be active in both scan mode 84 and coexistence mode 82 (e.g., to adjust or tune the gain of scan LNA 52 while amplifying incident radio-frequency energy/signals). Terminal 144 may form a dummy path (e.g., for dummy voltage VDM) that serves to absorb additional/excess current in the gain control path.

If desired, a termination resistance 161 (e.g., one or more resistors) may be coupled between the gain control path and reference voltage 96 by switch 150. When operating in coexistence mode 82 (FIG. 5), switch 150 may be opened to decouple or remove resistance 161 from the gain control path. This may prevent resistance 161 from altering input impedance matching while in the coexistence mode. When operating in scan mode 84, switch 150 may be closed, coupling resistance 162 to the gain control path and forming a shunt path to reference voltage 96 through the resistor. This may configure resistance 162 to contribute to impedance matching in the scan mode. When switched into use while scan LNA 52 operates in the scan mode, resistance 162 does not substantially improve the NF of scan LNA 52, given the gain of the LNA in the scan mode. Resistance 162 is sometimes also referred to herein as shunt resistance 162 or switchable shunt resistance 162.

Scan mode path 76 may be implemented as a CMOS common source amplifier. The common source amplifier may have a common source stage that includes a first transistor 164 (e.g., a PMOS transistor) and a second transistor 174 (e.g., an NMOS transistor), collectively forming complementary pair of PMOS and NMOS transistors (e.g., a CMOS inverter). Implementing scan mode path 76 using a single common source stage may cause the scan LNA to exhibit a superior NF than when implemented as a cascode amplifier having both a common source stage and a common gate stage.

The first source-drain terminal (e.g., source terminal) of transistor 164 may be coupled to bias terminal 162 (e.g., a power supply voltage terminal or rail of scan LNA 52 that receives a power supply voltage from power supply circuitry in device 10). The second source-drain terminal (e.g., drain terminal) of transistor 164 may be coupled to circuit node 168 and the second source-drain terminal (e.g., drain terminal) of transistor 174. The first source-drain terminal (e.g., source terminal) of transistor 174 may be coupled to reference voltage 96. Circuit node 168 may be communicatively coupled to output 80 of scan LNA 52 through capacitance 188 (e.g., one or more capacitors). Put differently, capacitance 188 may couple circuit node 168 to output 80 of scan LNA 52.

Scan mode path 76 may include a resistance 166 (e.g., one or more resistors), switching circuitry such as switches 182, 184, and 176, a first capacitance 186 (e.g., one or more capacitors), a second capacitance 180 (e.g., one or more capacitors), a third capacitance 178 (e.g., one or more capacitors), and a resistance 172 (e.g., one or more resistors). Switch 182 may couple the gate terminal of transistor 164 to capacitance 180. Capacitance 180 may couple switch 182 to circuit node 181. Circuit node 181 may be coupled to circuit node 120 (e.g., circuit node 181 may be communicatively coupled to input 78 of scan LNA 52 via circuit node 120). While referred to herein as separate circuit nodes for the sake of clarity, circuit nodes 116, 120, and 181 may also be referred to collectively as forming a single circuit node (e.g., coupled to input 78 of scan LNA 52, switch 184, and capacitors 112, 114, 128, 130, 180, and 178).

Capacitance 186 may couple circuit node 168 and thus the second source-drain terminals of transistors 164 and 174 to switch 184. Switch 184 may couple capacitance 186 to circuit node 181 (e.g., switch 184 may be coupled in series between capacitance 186 and circuit node 181 and capacitance 186 may be coupled in series between circuit node 168 and switch 184). Capacitance 178 may couple circuit node 181 to circuit node 177. Switch 176 may couple circuit node 177 to the gate terminal of transistor 174. Resistance 172 may couple circuit node 177 to bias terminal 170. Bias terminal 170 may receive a corresponding bias voltage (e.g., different than the bias voltage supplied to bias terminal 162).

If desired, an adjustable capacitance such as capacitance 158 may be switchably coupled between output 80 (or circuit node 155) and reference voltage 96 by switch 160. Switch 160 may be turned on to couple capacitance 158 into use, forming a shunt path to reference voltage 96 from output 80 (or circuit node 155). Switch 160 may be turned off to decouple capacitance 158 from output 80 (or circuit node 155). Capacitance 158 is sometimes also referred to herein as shunt capacitance 158 or switchable shunt capacitance 158.

Control signal SCTRL (FIGS. 3 and 4) may include one or more switch control signals that control the states of switches 104, 182, 184, and 176 to switch scan LNA 52 between coexistence mode 82 and scan mode 84 (FIG. 5). In coexistence mode 82, switch 104 may be turned on (closed) to activate coexistence mode path 72 (e.g., coupling coexistence mode path 72 into use between input 78 and output 80). The cascode amplifier in coexistence mode path 72 may amplify a signal received at input 78 and may output the amplified signal at output 80. Implementing coexistence mode path 72 using a cascode amplifier may serve to improve isolation between the receivers and may serve to improve gain control relative to implementations without a cascode amplifier. The cascode amplifier may also serve to present a high input impedance to scan LNA 52, which may configure the circuitry of primary LNA 50 (FIG. 3) to dominate impedance matching with matching network 68. In addition, coexistence mode path 72 may exhibit reduced DC current consumption because primary LNA 50 provides noise matched input impedance, improving the NF of scan receiver 32S.

At the same time, in coexistence mode 82, switches 182, 184, and 176 may be turned off (opened) to deactivate scan mode path 76 (e.g., decoupling scan mode path 76 from input 78 and/or output 80 of scan LNA 52). This may serve to shut down current consumption by scan mode path 76 while also decoupling the components to the right of switches 182, 184, and 176 in scan mode path 76 from circuit node 120, which may help to prevent the scan mode path from impacting the impedance matching performed by primary LNA 50.

On the other hand, in scan mode 84, switch 104 may be turned off (opened) to deactivate coexistence mode path 72 (e.g., decoupling coexistence mode path 72 from input 78 and/or output 80 of scan LNA 52). At the same time, switches 182, 184, and 176 may be turned on (closed). This may couple capacitor 180 to the gate terminal of transistor 164, may couple circuit node 181 to capacitor 186, and may couple circuit node 177 to the gate terminal of transistor 174. The common source amplifier in scan mode path 76 may amplify a signal received at input 78 and may output the amplified signal at output 80. Capacitor 186 may form a shunt feedback capacitance between the second source-drain terminals of transistors 164 and 174 and the gate terminals of transistors 164 and 174 (see, e.g., a first feedback path from circuit node 168, through capacitance 186, through switch 184, through capacitance 180, and through switch 182 to the gate terminal of transistor 164, and a second feedback path from circuit node 168, through capacitance 186, through switch 184, through capacitance 178, and through switch 176 to the gate terminal of transistor 174). This shunt feedback capacitance may serve to perform impedance matching between scan LNA 52 and matching network 68 (FIG. 3), effectively incorporating impedance matching into scan mode path 76 of scan LNA 52 while operating in the scan mode, without requiring an external resistive termination at node 53 (FIG. 3) that would otherwise deteriorate NF. Capacitance 188 may serve as an AC coupling capacitor between circuit node 168 and output 80. Capacitance 158 may be switched into use and may help to compensate for the gain difference between coexistence mode path 72 and scan mode path 76 while scan LNA operates in scan mode 84.

The example of FIG. 6 is illustrative and non-limiting. If desired, the switching circuitry used to activate/deactivate coexistence mode path 72 (e.g., switch 104) may include any desired number of one or more switches and the switch(es) may, if desired, be located elsewhere in or along coexistence mode path 72 (e.g., between circuit node 116 and capacitance 112, between circuit node 116 and capacitance 114, between capacitance 112 and circuit node 113, between capacitance 114 and circuit node 115, between circuit node 113 and the gate terminal of transistor 90, between circuit node 115 and the gate terminal of transistor 100, between circuit node 116 and circuit node 120, etc.). If desired, the switching circuitry used to activate/deactivate scan mode path 76 (e.g., switches 182, 184, and 176) may include any desired number of one or more switches and the switch(es) may, if desired, be located elsewhere in or along scan mode path 76 (e.g., between circuit node 181 and circuit node 120, between capacitor 186 and circuit node 168, etc.).

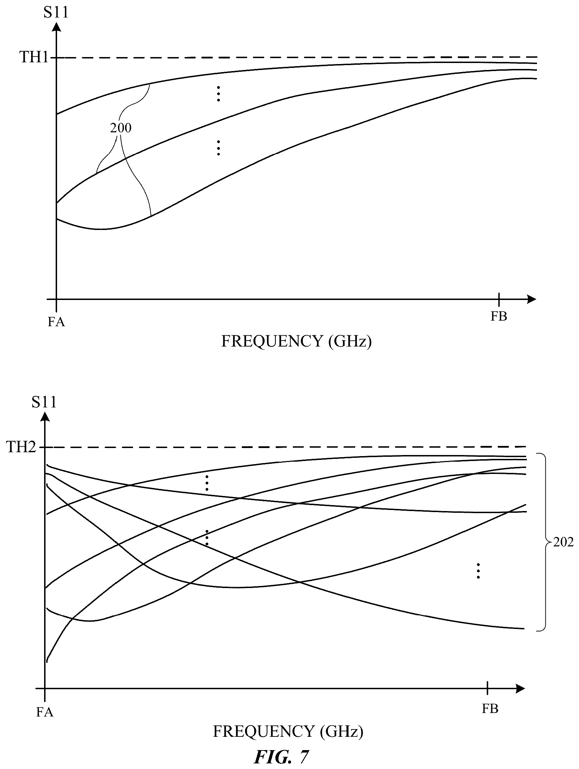

FIG. 7 includes plots that illustrate the impedance matching between scan LNA 52 and matching network 68 in scan mode 84 and coexistence mode 82. Curves 200 of FIG. 7 plot the reflection coefficient (e.g., the magnitude of scattering parameter S11 in dB) of scan LNA 52 while operating in scan mode 84 (e.g., while the circuitry of scan mode path 76 performs impedance matching for the scan LNA) as a function of frequency across different process, voltage, and/or temperature variations/corners (e.g., for both high power and low power configurations). As shown by curves 200, scan LNA 52 may exhibit a reflection coefficient below threshold TH1 (e.g., -8 dB, -7 dB, etc.), indicative of satisfactory impedance matching, across a frequency band from frequency FA to frequency FB (e.g., from around 2.4 GHz to around 2.5 GHz).

Curves 202 of FIG. 7 plot the reflection coefficient (e.g., the magnitude of scattering parameter S11 in dB) of scan LNA 52 while operating in coexistence mode 82 (e.g., while the circuitry primary LNA 50 performs impedance matching for the scan LNA) as a function of frequency across different process, voltage, and/or temperature variations/corners (e.g., for both high power and low power configurations). As shown by curves 202, scan LNA 52 may exhibit a reflection coefficient having a magnitude below threshold TH2 (e.g., -8 dB, -9 dB, -10 dB, -11 dB, etc.), indicative of satisfactory impedance matching, across a frequency band from frequency FA to frequency FB (e.g., from around 2.4 GHz to around 2.5 GHz). This example is illustrative. In practice, curves 200 and 202 may have other shapes. Frequencies FA and FB may be any desired frequencies.

The methods and operations described above in connection with FIGS. 1-7 may be performed by the components of device 10 using software, firmware, and/or hardware (e.g., dedicated circuitry or hardware). Software code for performing these operations may be stored on non-transitory computer readable storage media (e.g., tangible computer readable storage media) stored on one or more of the components of device 10 (e.g., storage circuitry 16 and/or wireless communications circuitry 24 of FIG. 1). The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of device 10 (e.g., processing circuitry in wireless circuitry 24, processing circuitry 18 of FIG. 1, etc.). The processing circuitry may include microprocessors, application processors, digital signal processors, central processing units (CPUs), application-specific integrated circuits with processing circuitry, or other processing circuitry.

As used herein, the term "concurrent" means at least partially overlapping in time. In other words, first and second events are referred to herein as being "concurrent" with each other if at least some of the first event occurs at the same time as at least some of the second event (e.g., if at least some of the first event occurs during, while, or when at least some of the second event occurs). First and second events can be concurrent if the first and second events are simultaneous (e.g., if the entire duration of the first event overlaps the entire duration of the second event in time) but can also be concurrent if the first and second events are non-simultaneous (e.g., if the first event starts before or after the start of the second event, if the first event ends before or after the end of the second event, or if the first and second events are partially non-overlapping in time). As used herein, the term "while" is synonymous with "concurrent."

It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

In accordance with an embodiment, a radio-frequency amplifier includes a first cascode amplifier coupled between an input and an output of the radio-frequency amplifier; a second cascode amplifier coupled between the input and the output in parallel with the first cascode amplifier; and a common source amplifier coupled between the input and the output in parallel with the first and second cascode amplifiers, where the radio-frequency amplifier is switchable between a first mode and a second mode, the first cascode amplifier is active and the common source amplifier is inactive while the radio-frequency amplifier is in the first mode, and the first cascode amplifier is inactive and the common source amplifier is active while the radio-frequency amplifier is in the second mode.

In accordance with another embodiment, the common source amplifier optionally includes a first transistor having a first source-drain terminal, a second transistor having a second source-drain terminal, a first capacitance coupled to the first source-drain terminal and the second source-drain terminal, and a first switch that couples the first capacitance to the input of the radio-frequency amplifier.

In accordance with another embodiment, the first switch is optionally open while the radio-frequency amplifier is in the first mode and is closed while the radio-frequency amplifier is in the second mode.

In accordance with another embodiment, the first source-drain terminal and the second source-drain terminal are optionally coupled to a first circuit node, the first capacitance is coupled between the first circuit node and the first switch, the first switch is coupled between the first capacitance and a second circuit node, and the common source amplifier further includes a second capacitance coupled to the second circuit node and a third capacitance coupled to the second circuit node.

In accordance with another embodiment, the radio-frequency amplifier optionally further includes a second switch, where the second capacitance is coupled between the second circuit node and the second switch, the second switch is coupled between the second capacitance and a gate terminal of the first transistor, the second switch is open while the radio-frequency amplifier is in the first mode, and the second switch is closed while the radio-frequency amplifier is in the second mode.

In accordance with another embodiment, the radio-frequency amplifier optionally further includes a third switch, where the third capacitance is coupled between the second circuit node and a third circuit node, the third switch is coupled between the third circuit node and a gate terminal of the second transistor, the third switch is open while the radio-frequency amplifier is in the first mode, and the third switch is closed while the radio-frequency amplifier is in the second mode.

In accordance with another embodiment, the radio-frequency amplifier optionally further includes a first resistance coupled between the gate terminal of the first transistor and the first source-drain terminal, and a second resistance coupled between the third circuit node and a first bias terminal.

In accordance with another embodiment, the first transistor optionally has a third source-drain terminal coupled to a second bias terminal and the second transistor has a fourth source-drain terminal coupled to a reference voltage.

In accordance with another embodiment, the radio-frequency amplifier is optionally disposed on a substrate and the first capacitance is configured to perform, while the radio-frequency amplifier is in the second mode, impedance matching between the radio-frequency amplifier and a matching network external to the substrate.

In accordance with another embodiment, the radio-frequency amplifier optionally further includes a shunt capacitance, where the shunt capacitance is decoupled from the output while the radio-frequency amplifier is in the first mode and is coupled to the output while the radio-frequency amplifier is in the second mode.

In accordance with another embodiment, the second cascode amplifier optionally includes a gain control amplifier that includes a common source stage and first and second common gate stages coupled in parallel between transistors of the common source stage, further including a shunt resistance, where the shunt resistance is decoupled from the gain control amplifier while the radio-frequency amplifier is in the first mode and is coupled to the gain control amplifier while the radio-frequency amplifier is in the second mode.

In accordance with another embodiment, the radio-frequency amplifier optionally includes a low noise amplifier in a scan receiver.

In accordance with an embodiment, wireless circuitry includes a radio-frequency transmission line path; a first low noise amplifier (LNA) communicatively coupled to the radio-frequency transmission line path; and a second LNA communicatively coupled to the radio-frequency transmission line path, where the second LNA consumes less power than the first LNA, the first LNA and the second LNA are active while the wireless circuitry is in a first state, the first LNA is inactive and the second LNA is active while the wireless circuitry is in a second state, and the second LNA includes matching circuitry that is configured to perform impedance matching to the radio-frequency transmission line path while the wireless circuitry is in the second state.

In accordance with another embodiment, the first LNA optionally includes additional matching circuitry that is configured to perform impedance matching to the radio-frequency transmission line path while the wireless circuitry is in the first state, the second LNA further includes switching circuitry configured to decouple the matching circuitry from the radio-frequency transmission line path while the wireless circuitry is in the first state.

In accordance with another embodiment, the second LNA optionally further includes a first amplifier path, a second amplifier path coupled in parallel with the first amplifier path between an input and an output of the second LNA, and a third amplifier path coupled in parallel with the first and second amplifier paths between the input and the output, where the third amplifier path includes the matching circuitry.

In accordance with another embodiment, the first amplifier path is active, the second amplifier path is active, and the third amplifier path is inactive while the wireless circuitry is in the first state, and the first amplifier path is inactive, the second amplifier path is active, and the third amplifier path is active while the wireless circuitry is in the second state.

In accordance with another embodiment, the third amplifier path optionally includes a common source amplifier coupled between the output and the matching circuitry, where the matching circuitry includes a feedback capacitor that is switchably coupled between source-drain terminals and gate terminals of transistors in the common source amplifier.

In accordance with another embodiment, the first amplifier path optionally includes a first cascode amplifier and the second amplifier path includes a second cascode amplifier, the second cascode amplifier being configured to control a gain of the second LNA.

In accordance with another embodiment, the wireless circuitry optionally further includes processing circuitry, where the first LNA and the second LNA are coupled in parallel between the radio-frequency transmission line path and the processing circuitry, and an analog-to-digital converter (ADC) coupled between the second LNA and the processing circuitry, where the processing circuitry is configured to switch the wireless circuitry from the second state to the first state responsive to detection of a signal in a digital output of the ADC.

In accordance with an embodiment, wireless circuitry includes a substrate; a first receiver on the substrate and including a first amplifier; and a second receiver on the substrate and including a second amplifier that is configured to scan for a signal that triggers activation of the first receiver, where the first amplifier is configured to perform impedance matching between the substrate and a matching network external to the substrate while the first receiver is active, the second amplifier includes a common source inverter that includes a first transistor, a second transistor, a capacitor coupled to a first source-drain terminal of the first transistor and a second source-drain terminal of the second transistor, and switching circuitry, the switching circuitry switchably couples the capacitor to a gate terminal of the first capacitor and a gate terminal of the second capacitor, and the capacitor is configured to perform impedance matching between the substrate and the matching network while the first receiver is inactive.

The foregoing is merely illustrative and various modifications can be made to the described embodiments. The foregoing embodiments may be implemented individually or in any combination.

## Claims

1. A radio-frequency amplifier comprising:
a first cascode amplifier coupled between an input and an output of the radio-frequency amplifier;
a second cascode amplifier coupled between the input and the output in parallel with the first cascode amplifier; and
a common source amplifier coupled between the input and the output in parallel with the first and second cascode amplifiers, wherein
the radio-frequency amplifier is switchable between a first mode and a second mode,
the first cascode amplifier is active and the common source amplifier is inactive while the radio-frequency amplifier is in the first mode, and
the first cascode amplifier is inactive and the common source amplifier is active while the radio-frequency amplifier is in the second mode.

2. The radio-frequency amplifier of claim 1, wherein the common source amplifier comprises:
a first transistor having a first source-drain terminal;
a second transistor having a second source-drain terminal;
a first capacitance coupled to the first source-drain terminal and the second source-drain terminal; and
a first switch that couples the first capacitance to the input of the radio-frequency amplifier.

3. The radio-frequency amplifier of claim 2, wherein the first switch is open while the radio-frequency amplifier is in the first mode and is closed while the radio-frequency amplifier is in the second mode.

4. The radio-frequency amplifier of claim 3, wherein the first source-drain terminal and the second source-drain terminal are coupled to a first circuit node, the first capacitance is coupled between the first circuit node and the first switch, the first switch is coupled between the first capacitance and a second circuit node, and the common source amplifier further comprises:
a second capacitance coupled to the second circuit node; and
a third capacitance coupled to the second circuit node.

5. The radio-frequency amplifier of claim 4, further comprising:
a second switch, wherein the second capacitance is coupled between the second circuit node and the second switch, the second switch is coupled between the second capacitance and a gate terminal of the first transistor, the second switch is open while the radio-frequency amplifier is in the first mode, and the second switch is closed while the radio-frequency amplifier is in the second mode.

6. The radio-frequency amplifier of claim 5, further comprising:
a third switch, wherein the third capacitance is coupled between the second circuit node and a third circuit node, the third switch is coupled between the third circuit node and a gate terminal of the second transistor, the third switch is open while the radio-frequency amplifier is in the first mode, and the third switch is closed while the radio-frequency amplifier is in the second mode.

7. The radio-frequency amplifier of claim 6, further comprising:
a first resistance coupled between the gate terminal of the first transistor and the first source-drain terminal; and
a second resistance coupled between the third circuit node and a first bias terminal.

8. The radio-frequency amplifier of claim 7, wherein the first transistor has a third source-drain terminal coupled to a second bias terminal and the second transistor has a fourth source-drain terminal coupled to a reference voltage.

9. The radio-frequency amplifier of claim 6, wherein the radio-frequency amplifier is disposed on a substrate and wherein the first capacitance is configured to perform, while the radio-frequency amplifier is in the second mode, impedance matching between the radio-frequency amplifier and a matching network external to the substrate.

10. The radio-frequency amplifier of claim 1, further comprising:
a shunt capacitance, wherein the shunt capacitance is decoupled from the output while the radio-frequency amplifier is in the first mode and is coupled to the output while the radio-frequency amplifier is in the second mode.

11. The radio-frequency amplifier of claim 1, wherein the second cascode amplifier comprises a gain control amplifier that includes a common source stage and first and second common gate stages coupled in parallel between transistors of the common source stage, further comprising:
a shunt resistance, wherein the shunt resistance is decoupled from the gain control amplifier while the radio-frequency amplifier is in the first mode and is coupled to the gain control amplifier while the radio-frequency amplifier is in the second mode.

12. The radio-frequency amplifier of claim 1, wherein the radio-frequency amplifier comprises a low noise amplifier in a scan receiver.
